# EUROPEAN PATENT SPECIFICATION

(11) **EP 1 044 113 B1**
(45) Date of publication and mention of the grant of the patent: **01.03.2006**
(21) Application number: 98966483.4
(22) Date of filing: 31.12.1998
(51) Int. Cl.: B44C 1/22, H01J 37/32

(54) **PLASMA DISCHARGE DEVICE AND METHOD WITH DYNAMIC TUNING**
GERÄT UND METHODE ZUR PLASMAENTLADUNG MIT DYNAMISCHER REGELUNG
DISPOSITIF DE DECHARGE DE PLASMA ET PROCEDE DE REGLAGE DYNAMIQUE

(30) Priority: 31.12.1997 US 1635
(43) Date of publication of application: 18.10.2000
(73) Proprietor: Axcelis Technologies, Inc., Beverly, MA 01915-1053 (US)
(72) Inventor: SRIVASTAVA, Aseem, K., Gaithersburg, MD 20879 (US); PINGREE, Richard, E., New Market, MD 21774 (US); PELLICIER, Victor, Monrovia, MD 21770 (US)
(74) Representative: Burke, Steven David
(86) International application number: PCT/US1998/027886
(87) International publication number: WO 1999/033673

(56) References cited:
- WO-A-97/37055
- US-A- 4 507 588
- US-A- 4 943 345
- US-A- 5 038 713
- US-A- 5 389 153
- US-A- 5 498 308

## Description

### BACKGROUND OF THE INVENTION

The present invention is directed to an improved plasma discharge device and method for removing material from a substrate.

In the manufacture of semiconductor devices, it is frequently necessary to remove a substance from a substrate. Embodiments of the present invention are broadly applicable to such processes, and for example, would include specific processes relating to residue removal, chemical downstream etching (CDE), and etching.

It is known to use plasma discharge devices to remove a substance from a substrate, and these may be of the "afterglow" type, where it is the afterglow of the plasma rather than the plasma itself which accomplishes removal. While the gas used in the plasma is frequently oxygen, as for ashing applications, it may be a different gas such as a fluorine containing gas for other applications, as when materials such as heavily metallized polymeric residues are to be removed.

In a plasma discharge device, a gas is flowed through a plasma tube which is located in a microwave cavity, and a plasma is excited in the gas by microwave energy. Then, the plasma, or the afterglow therefrom is used to remove the material from the substrate.

One drawback of many plasma discharge devices for material removal is that they are designed for use with only a single type of gas, e.g., oxygen, or fluorine containing gas, as the case may be. This results in added expense since, when a process using a different gas is to be performed, a new piece of equipment must be used.

### SUMMARY OF THE INVENTION

Aspects of the invention are provided in the accompanying claims.

In accordance with a preferred embodiment of the present invention, a plasma discharge device is provided which may be used with different fill gases over a wide range of process conditions. This is accomplished by providing a device which is broadly tunable, so that an appropriate resonant microwave mode may be achieved even when different gases and different operating conditions are present.

The dynamic tuning of embodiments of the present invention is achieved by defining at least one end of a longitudinally extending microwave cavity with a microwave trap, and arranging for the longitudinal position of the microwave trap to be adjustable. In a preferred embodiment of the invention, each end of the cavity is defined by a microwave trap, and the longitudinal positions of both traps are adjustable.

In accordance with a further aspect of preferred embodiments of the invention, the microwave power is coupled to the cavity with an antenna which extends into the cavity, the degree of insertion of which into the cavity is adjustable. This provides a further tuning adjustment, so that coupling of the desired microwave mode may be enhanced while the operating window is enlarged.

In accordance with a further aspect of preferred embodiments of the invention, a moveable microwave trap is provided which does not require finger stock between the trap and the microwave cavity.

In accordance with a still further aspect of preferred embodiments of the invention, a system for automatically adjusting the respective positions of the trap and antenna to the optimum positions for any given process is provided.

In accordance with a still further aspect of preferred embodiments of the invention, the cavity is excited with microwave power in the resonant cylindrical TM₀₁₂ mode. In a prior plasma discharge device, which provided microwave modes having azimuthal and longitudinal uniformity to prevent cracking of the plasma tube, it was necessary to separate the elongated microwave cavity into sections with metallic partitions to create sub-cavities which were small enough to support such modes (see, for example, WO97/37055). By providing an adjustable cavity length to excite the cylindrical TM₀₁₂ mode, the need for such cavity partitioning is avoided, while azimuthal uniformity and an adequate degree of longitudinal uniformity is provided.

### BRIEF DESCRIPTION OF DRAWINGS

The invention will be better appreciated by referring to the drawings, wherein:
Figure 1 is a cross-sectional view of a plasma discharge device.
Figure 2 is a perspective view with partial cutaway, of the plasma discharge device of Figure 1.
Figure 3 shows the structure relating to the antenna configuration in greater detail.
Figure 4 shows alternative structure relating to the antenna configuration.
Figure 5 shows a slidable microwave trap.
Figures 6, 7 and 8 show components of the slidable trap.
Figure 9 is a block diagram of a system for automatically adjusting the positions of the movable trap and the antenna.
Figure 10 shows an embodiment of a microwave feed for a plasma discharge device.

### DETAILED DESCRIPTION OF PREFERRED EMBODIMENTS

Referring to the Figures, longitudinally extending cylindrical microwave cavity 2 is depicted, which has cylindrical plasma tube 4 running therethrough. The plasma tube may be made of quartz or sapphire, or other substance which is appropriate for the gas which is used.

In order to excite the gas flowing in plasma tube 4 to a plasma state, microwave excitation must be provided. To this end, microwave source 6, e.g., a magnetron, generates microwave power which is fed through directional coupler 7 to a waveguide having mutually perpendicular sections 8 and 9. The length of section 9 is controlled with moveable short 10, which may be a fixed rather than a moveable member if desired. An antenna 12 in the form of a metallic rod is provided for coupling microwave power from the waveguide to the cavity via a waveguide to coaxial transition. The antenna extends through a circular opening in the cavity wall into the cavity, and its degree of insertion is adjustable. The adjustment is accomplished by pushing or pulling on member 13 which is attached to antenna 12 with pin 15, thus causing antenna 12 to move in and out of the cavity. Member 13 is made of a low loss electrical insulator of low dielectric constant, e.g., polytetrafluorethylene, to prevent microwave leakage through the insertion hole. A screw mechanism including a stepping motor may be provided for automating the insertion and retraction of the antenna. As described above, the antenna adjustment allows the coupling of the field to the cavity to be optimized for specific operating conditions and increases the operating window of the system.

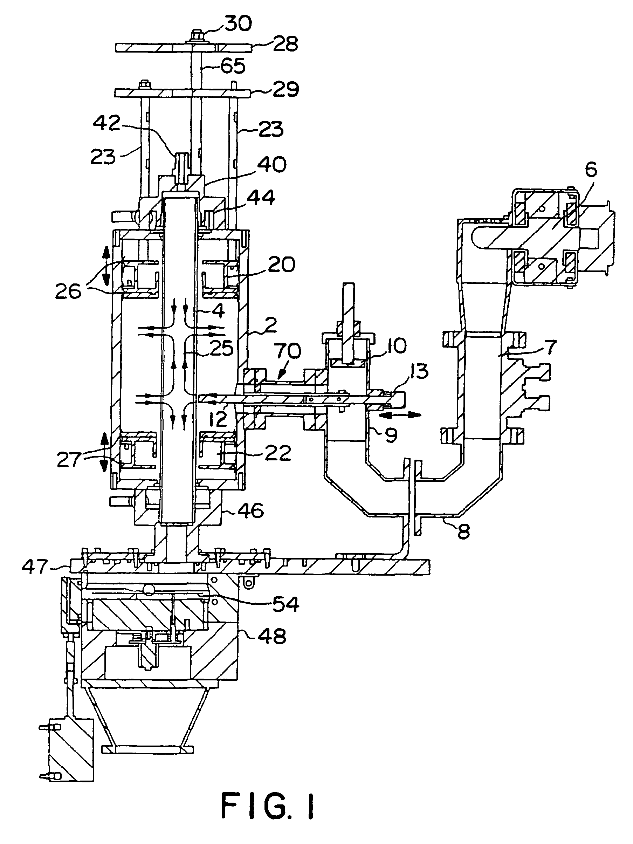

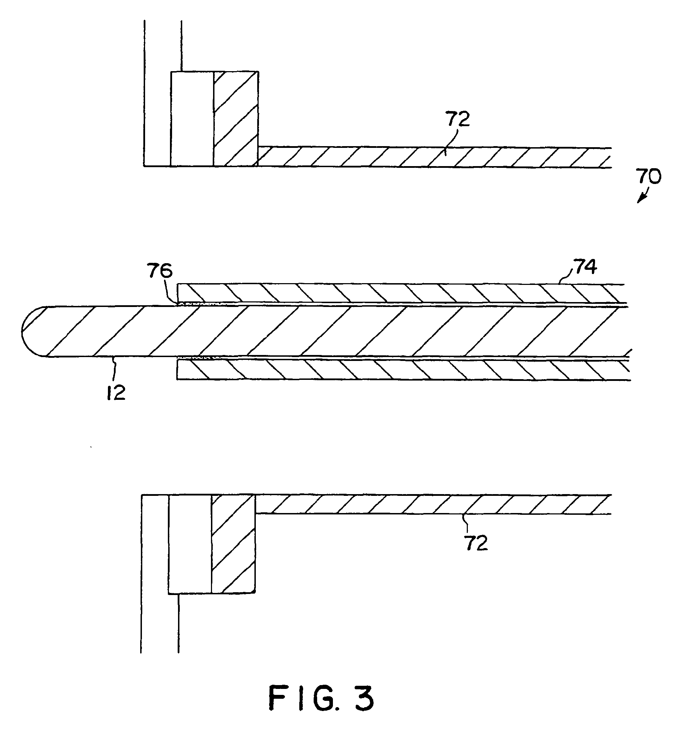

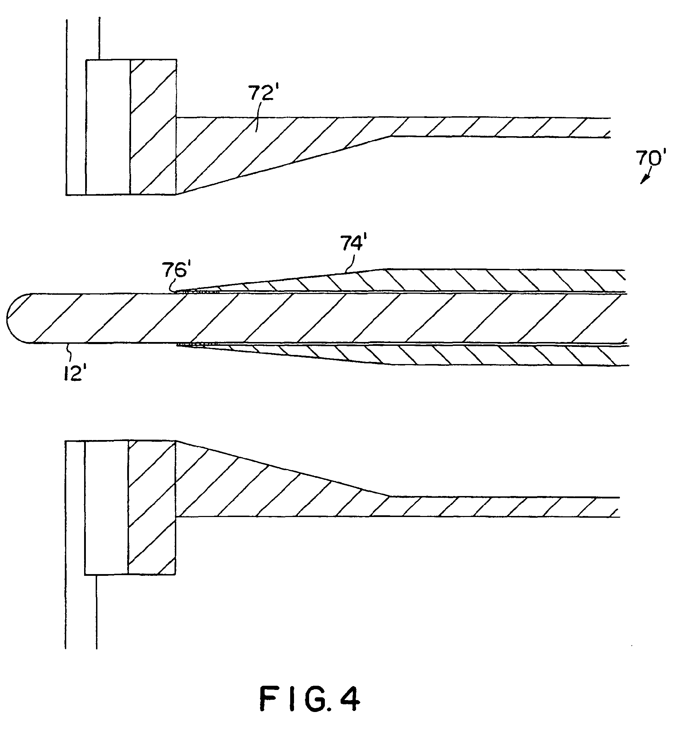

Figure 3 is a detail of coaxial structure 70 shown in Figure 1. The coaxial structure is comprised of outer conductor 72 and an inner conductor comprised of sleeve 74 and antenna 12 which slides in sleeve 74 with the aid of finger stock contact ring 76. An altemative embodiment is shown in Figure 4, wherein like parts are identified with the same numerals. In Figure 4, coaxial structure 70' is comprised of outer conductor 72' and an inner conductor comprised of sleeve 74' and antenna 12' which slides therein. In the embodiment of Figure 4, the inner surface of outer conductor 72' and the outer surface of sleeve 74' are tapered so as to provide a gradual change in impedance, thereby providing better impedance matching between the waveguide 9 and the cavity 2.

The ends of the microwave cavity are defined by microwave traps 20 and 22. Such traps are a very effective way of preventing microwave leakage since they electrically reduce the microwave current to zero. The traps may be of the type disclosed in U.S. Patent 5,498,308.

In accordance with an aspect of preferred embodiments the present invention, the longitudinal position of microwave traps 20 and 22 is adjustable. For example, the adjustment may be facilitated by disposing finger stock 26 and 27 between the traps and the cavity wall, which are compressible protrusions, thus rendering the microwave traps longitudinally slidable.

Additionally, a screw mechanism may be provided for conveniently effecting the adjustment of the traps, and such a mechanism is shown in connection with the top trap 20 in the Figures. It is comprised of horizontal (in the Figures) members 28 and 29, and vertical (in the Figures) cylindrical members 23, 65, and 60. There are three members 23, (not all shown) which connect the top of top trap 20 to member 29. There are three members 65, (not all shown) which connect the top of the microwave cavity to member 28, where they are secured with nuts 30 (only one shown). Member 60 is threaded, as is an opening in member 29 through which in turn raises or lowers the microwave trap 20. If desired a stepper motor may be employed in a configuration for automating the raising and lowering of the trap. A similar mechanism (not shown) can be employed for moving the bottom trap 22.

The adjustment of the cavity length provides a broad range of dynamic cavity tuning, and is what permits the device to be operated with different gasses over a wide range of process conditions. As is known to those skilled in the art, utilizing a different gas will change the load impedance and resonant frequency of the cavity, and effectively of the cavity, thereby detuning it. Re-tuning may be accomplished by experimenting with the positions of the slidable traps to establish a resonant TM₀₁₂ mode in the cavity. That is, the cavity is nominally dimensioned to result in the TM₀₁₂ mode, and the dynamic tuning permits resonance to be maintained over a variety of process gasses. In addition to the use of different gasses, a broad range of process conditions, e.g., gas flow, pressure, input power, etc. can be accommodated.

While preferred embodiments of the invention are operable by making the position of only one trap adjustable, a big advantage is afforded when both traps are moveable. This is because the position of each trap may be independently changed in relation to the position of the antenna, thus affording a greater range of effective tuning.

The device may be air cooled by providing a quartz tube close to and concentric with plasma tube 4, and feeding pressurized air in the space between the tubes, or if desired, may be liquid cooled with a high specific heat liquid that is microwave transparent and clean room friendly by feeding such substance between the concentric tubes.

Referring to Figure 1, it is seen that end cap 40 is provided which abuts the top of the cavity, while fitting 42 having a central orifice for admitting gas to the plasma tube extends into the end cap. The plasma tube is supported at this end by O ring 44 in the end cap. End member 46 is provided at the other end to provide the proper spacing in relation to bottom plate 47 and the process chamber 48, while this end of the plasma tube has an opening in it for emission into the process chamber.

In the operation of the device, oxygen, fluorine containing gas, or other gas is fed into gas inlet 42, which feeds plasma tube 4. The microwave cavity is tuned to achieve a resonant TM₀₁₂ mode by adjusting the position of slidable microwave traps 20 and 22, and matching of the cavity impedance with plasma to the characteristic impedance of the coaxial section is accomplished by adjusting the insertion of antenna 12 into the cavity. A plasma is excited in the gas, the afterglow of which is emitted from an opening at the end of the plasma tube into process chamber 48. While embodiments of the invention are applicable to devices where either the plasma or the afterglow from the plasma is used to remove material, the preferred embodiment is an afterglow device.

The TM₀₁₂ field configuration is depicted in Figure 1 at reference numeral 25. To prevent cracking of a sapphire plasma tube, it is necessary to prevent unequal heating of the tube, and a field configuration having azimuthal and longitudinal uniformity will accomplish this. The TM₀₁₂ field has azimuthal uniformity (not shown), and as seen in Figure 1 also has adequate longitudinal uniformity. Thus, it has been found that use of the TM₀₁₂ field configuration obviates cracking of the plasma tube, and as mentioned above, does not require a cavity which uses partitioning.

The process chamber 48 includes retractable wafer support pins which support wafer 54, to be processed. A chuck is arranged to provide the correct heating to the wafer during processing. One or more baffle plates may be present above the wafer to promote even distribution of the gas.

A disadvantage of the slidable microwave trap shown in Figure 1 is that it utilizes mechanical finger stock between it and the microwave cavity for enabling sliding motion. The finger stock may grind against the microwave cavity and create particles which could contaminate the processing, it may wear out and have to be replaced, and it may otherwise fail, so it is desirable to be able to eliminate it.

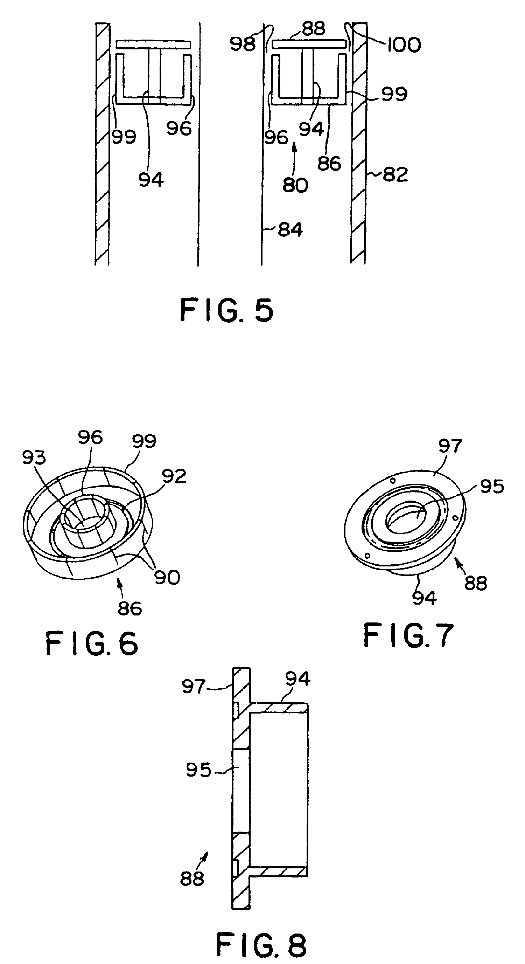

This is what is accomplished in the embodiment depicted in Figure 5, wherein a particular sliding trap 80 is utilized in microwave cavity 82 having plasma tube 84. The trap is comprised of member 86, shown in perspective in Figure 6, and member 88 shown in perspective in Figure 7, and in cross-section in Figure 8. Member 86 is seen to have slits 90 and circular groove 92. Member 88 is inserted in member 86 (see Figure 5), so that cylindrical flange 94 of member 88 fits in groove 92.

The structure is electrically two concentric microwave sub-traps, each of the type shown in Figure 1 and described in detail in U.S. Patent No. 5,498,308. Thus, the inner sub-trap, referring to Figure 5, which includes cylinders 96 and 94 brings the microwave field in gap 98 to zero, while the outer trap, comprised of cylinders 94 and 99, brings the field in gap 100 to zero. Plasma tube 84 passes through central openings 93 and 95 in members 86 and 88 respectively. The length of the trap is substantially one quarter wavelength, and the spacing between cylinders 96 and 94, and between cylinders 94 and 99 is substantially equal.

Since the structure does not contact the microwave cavity, it is readily slidable therein, while effectively preventing microwave leakage.

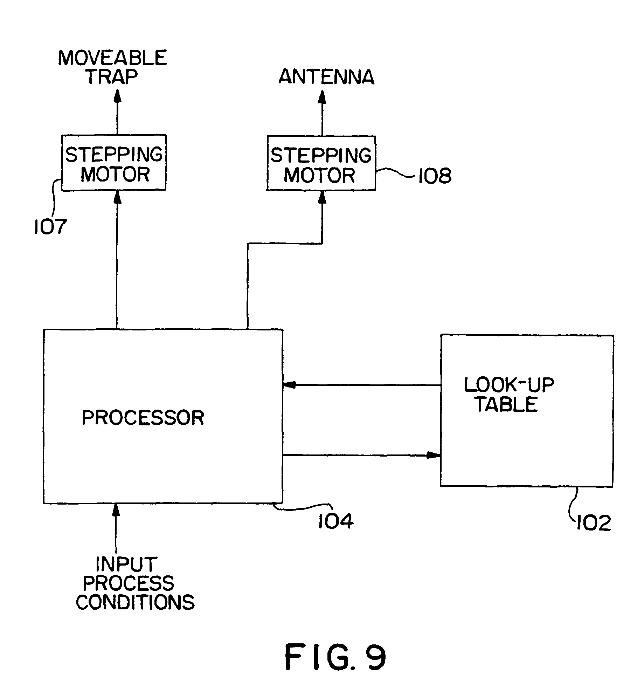

Turning to a further aspect of the invention, it is desirable for the respective positions of the moveable trap and antenna to be automatically adjusted to the best positions for any given process. The system which is shown in Figure 9 accomplish this.

As previously mentioned, an advantage of the invention is that the dynamic tuning feature permits the device to be used over a wide range of specific processes. For each different process, e.g., different fill gas or gasses and/or power level, there is a unique adjustment of trap and antenna positions which provides optimum operation, i.e., minimum reflected power.

Referring to Figure 9, look-up table 102 is provided, which may be in the form of a read only memory or software. The look-up table has programmed in it those values for trap and antenna positions which result in optimum operation. The data in look-up table 102 is established for each specific process by performing the following steps:
a) selecting an antenna position and while the process is performed, moving the trap through a range of positions, and recording the reflected power for each combination of positions,
b) moving the antenna position incrementally and again moving the trap through a range of positions and recording the reflected power for each combination of positions, and
c) repeating step b) until the reflected power value for each incremental combination of trap and antenna position is determined. These values comprise the look-up table.

In use of the system of Figure 9, an operator identifies the desired process to be performed to the processor 104, which then accesses look-up table 102. The processor is programmed to select the combination of trap and antenna positions which has the minimum value of reflected power recorded against them for the particular process involved. Such information is fed back to the processor, which then controls trap stepping motor 106 and antenna stepping motor 108 to move the trap and antenna to the indicated positions. If there are a few combinations of trap - antenna positions which result in very low reflected power, i.e., less than 5%, the processor may be programmed to provide an indication of all such positions, so that each may be empirically tried.

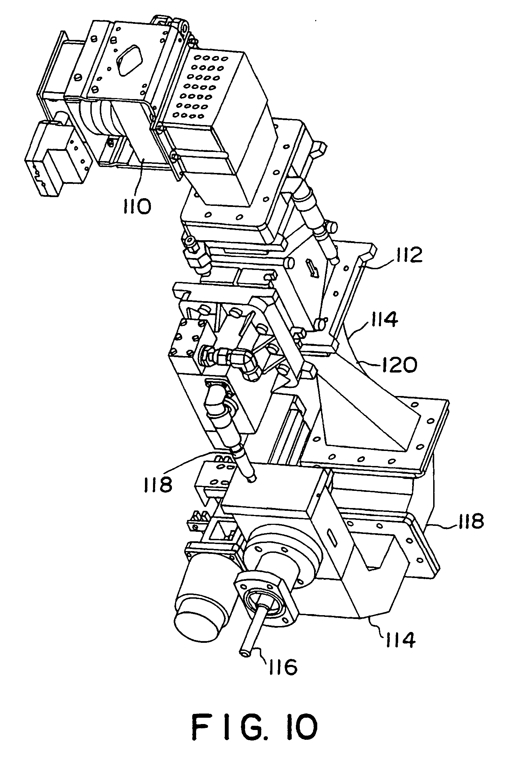

Figure 10 shows an embodiment of a microwave feed for the plasma discharge device of the invention. Referring to the Figure, magnetron 110 is coupled to circulator 112 and to waveguide 114 which drives antenna 116. Directional coupler 118 is also provided, as is reflected power sensor 118. There is a twist 120 in waveguide 114 to enable more compact packaging of the apparatus.

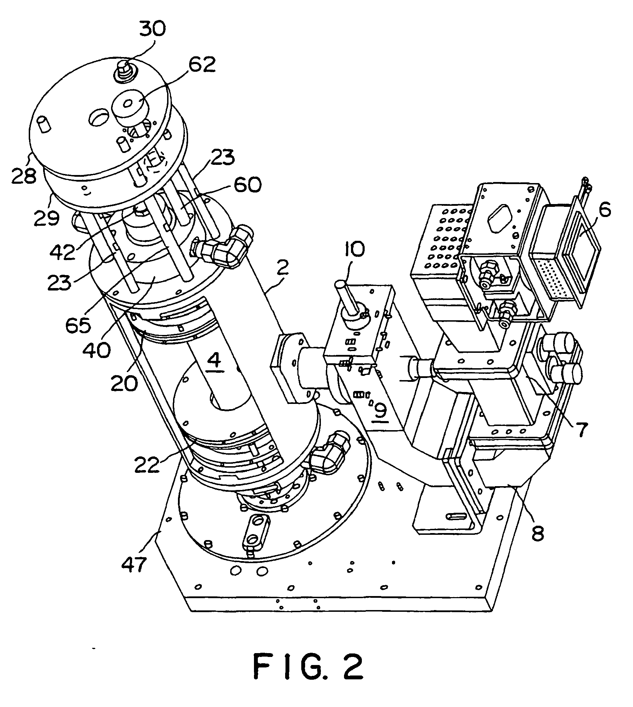

In an actual embodiment according to Figures 1 and 2, which was built, the magnetron frequency was 2443 Mhz, the microwave cavity had an internal diameter of 5.43 inches (13,8 cm) and was approximately 8.25 inches (21 cm) long with the microwave traps positioned to make the cavity as long as possible. The top microwave trap could be moved to shorten the cavity by about 3.5 inches (8,9 cm), while the bottom trap could be so moved by about .5 inch (1,3 cm). In use for removing polymeric residues, a plasma tube made of sapphire was used having an ID of 1.37 inches (3,48 cm) and a fluorine containing gas was flowed through the tube. The microwave power was about 2000 watts and the power density was about 11.8 watts/cc.

## Claims

1. A dynamically tunable plasma discharge device for removing material from a substrate, comprising
a longitudinally extending microwave cavity,
a plasma tube passing through said microwave cavity for containing gas when in operation,
means for providing a microwave field in said cavity for exciting gas when in said plasma tube to a plasma, and
an opening in said plasma tube for permitting said gas to exit,
**characterised in that**
at least one end of said microwave cavity is defined by a microwave trap which reduces a microwave current to zero, the position of which is longitudinally adjustable to provide dynamic tuning of said cavity.

2. The device of claim 1 wherein both ends of said microwave cavity are defined by microwave traps and the respective positions of both microwave traps are longitudinally adjustable to provide dynamic tuning of said cavity.

3. The device of claim 2 wherein said means for providing a microwave field in said cavity comprises microwave source means for providing microwave power and means for coupling said microwave power from said source means to said cavity, wherein said means for coupling includes an antenna which extends into said cavity, the degree of insertion of which into said cavity is adjustable.

4. The device of any preceding claim wherein said gas may be selected from a plurality of gases including oxygen containing gas and fluorine containing gas.

5. The device of any preceding claim further including means for utilizing said plasma or the afterglow therefrom to remove said material from said substrate.

6. The device of any preceding claim wherein the microwave trap is moveable within the cavity along the length thereof, and causes the field between the trap and the cavity to be zero without the use of any physical member between the trap and the cavity.

7. The device of claim 6 wherein the microwave trap is comprised of three concentric metallic cylindrical members.

8. The device of claim 7 wherein the three concentric metallic cylindrical members comprise an inner cylindrical member, an outer cylindrical member, and an intermediate cylindrical member between the inner and outer members, and wherein the plasma tube passes through the inner cylindrical member.

9. The device of claim 8 wherein the microwave trap causes the field between the plasma tube and the inner cylindrical member to be zero.

10. The device of claim 9 wherein the inner and outer cylindrical members are parts of a first piece, while the intermediate cylindrical member is part of a second piece, wherein the second piece is inserted in the first piece.

11. The device of claim 10 wherein the means for providing a microwave field in the cavity comprises microwave source means for providing microwave power and means for coupling the microwave power from the source means to the cavity, wherein the means for coupling includes an antenna which extends into the cavity, the degree of insertion of which into the cavity is adjustable.

12. The device of any preceding claim wherein the means for providing a microwave field in the cavity provides a field having a resonant cylindrical TM₀₁₂ mode.

13. The device of claim 1, wherein the means for providing a microwave field in the cavity comprises microwave source means for providing microwave power and means for coupling the microwave power from the source means to the cavity, wherein the means for coupling includes an antenna which extends into the cavity, the degree of insertion of which into the cavity is adjustable, further including means for any selected material removal process, for automatically adjusting the respective positions of the microwave trap and the antenna such that the reflected microwave power is at a minimum.

14. The device of claim 13 further including data storage means for storing data corresponding to microwave trap and antenna positions for various material removal processes.

15. The device of claim 14 wherein the microwave trap is comprised of an inner cylindrical member, an outer cylindrical member, and an intermediate cylindrical member between the inner and outer cylindrical members, and wherein the plasma tube passes through the inner cylindrical member.

## Revendications

1. Dispositif de décharge de plasma réglable de manière dynamique permettant de retirer un matériau d'un substrat, comprenant :
une cavité à micro-ondes s'étendant longitudinalement,
un tube à plasma passant à travers ladite cavité à micro-ondes, destiné à contenir un gaz en cours de fonctionnement,
des moyens adaptés pour produire un champ de micro-ondes dans ladite cavité afin d'exciter le gaz se trouvant dans ledit tube à plasma jusqu'à sa transformation en plasma, et
une ouverture dans ledit tube à plasma conçue pour permettre au dit gaz de sortir,
**caractérisé en ce que**
au moins une extrémité de ladite cavité à micro-ondes est définie par un piège à micro-ondes qui réduit un courant de micro-ondes à zéro, dont la position est ajustable longitudinalement de façon à permettre un réglage dynamique de ladite cavité.

2. Dispositif selon la revendication 1, dans lequel les deux extrémités de ladite cavité à micro-ondes sont définies par des pièges à micro-ondes et les positions respectives des deux pièges à micro-ondes sont ajustables longitudinalement de façon à permettre un réglage dynamique de ladite cavité.

3. Dispositif selon la revendication 2, dans lequel lesdits moyens adaptés pour produire un champ de micro-ondes dans ladite cavité comprennent des moyens formant source de micro-ondes destinés à produire une énergie de micro-ondes et des moyens destinés à coupler ladite énergie de micro-ondes provenant desdits moyens formant source à ladite cavité, dans lesquels lesdits moyens de couplage comprennent une antenne qui s'étend dans ladite cavité et dont le degré d'insertion dans ladite cavité est ajustable.

4. Dispositif selon une quelconque revendication précédente, dans lequel ledit gaz peut être choisi parmi une pluralité de gaz, notamment un gaz oxygéné et un gaz fluoré.

5. Dispositif selon une quelconque revendication précédente, comprenant en outre des moyens permettant d'utiliser ledit plasma ou la postluminescence résultant de celui-ci pour retirer ledit matériau dudit substrat.

6. Dispositif selon une quelconque revendication précédente, dans lequel le piège à micro-ondes peut être déplacé à l'intérieur de la cavité sur toute la longueur de celle-ci et amène le champ entre le piège et la cavité à une valeur nulle sans utilisation d'un quelconque élément physique entre le piège et la cavité.

7. Dispositif selon la revendication 6, dans lequel ledit piège à micro-ondes est composé de trois éléments cylindriques métalliques concentriques.

8. Dispositif selon la revendication 7, dans lequel les trois éléments cylindriques métalliques concentriques comprennent un élément cylindrique intérieur, un élément cylindrique extérieur et un élément cylindrique intermédiaire entre les éléments intérieur et extérieur, et dans lequel le tube à plasma passe à travers l'élément cylindrique intérieur.

9. Dispositif selon la revendication 8, dans lequel le piège à micro-ondes amène le champ entre le tube à plasma et l'élément cylindrique intérieur à une valeur nulle.

10. Dispositif selon la revendication 9, dans lequel les éléments cylindriques intérieur et extérieur font partie d'une première pièce, tandis que l'élément cylindrique intermédiaire fait partie d'une seconde pièce, la seconde pièce étant insérée dans la première pièce.

11. Dispositif selon la revendication 10, dans lequel les moyens adaptés pour produire un champ de micro-ondes dans la cavité comprennent des moyens formant source de micro-ondes destinés à produire une énergie de micro-ondes et des moyens destinés à coupler l'énergie de micro-ondes provenant des moyens formant source à la cavité, dans lesquels les moyens de couplage comprennent une antenne qui s'étend dans la cavité et dont le degré d'insertion dans la cavité est ajustable.

12. Dispositif selon une quelconque revendication précédente, dans lequel les moyens pour produire un champ de micro-ondes dans la cavité produisent un champ ayant un mode cylindrique résonant TM₀₁₂.

13. Dispositif selon la revendication 1, dans lequel les moyens pour produire un champ de micro-ondes dans la cavité comprennent des moyens formant source de micro-ondes destinés à produire une énergie de micro-ondes et des moyens destinés à coupler l'énergie de micro-ondes provenant des moyens formant source à la cavité, dans lesquels les moyens de couplage comprennent une antenne qui s'étend dans la cavité et dont le degré d'insertion dans la cavité est ajustable, comprenant en outre des moyens adaptés à un quelconque processus de retrait de matériau sélectionné, permettant d'ajuster automatiquement les positions respectives du piège à micro-ondes et de l'antenne de telle manière que l'énergie de micro-ondes réfléchie se situe à un minimum.

14. Dispositif selon la revendication 13, comprenant en outre des moyens de mémorisation de données pour mémoriser des données correspondant à des positions du piège à micro-ondes et de l'antenne pour divers processus de retrait de matériau.

15. Dispositif selon la revendication 14, dans lequel le piège à micro-ondes est composé d'un élément cylindrique intérieur, d'un élément cylindrique extérieur et d'un élément cylindrique intermédiaire entre les éléments cylindriques intérieur et extérieur, et dans lequel le tube à plasma passe à travers l'élément cylindrique intérieur.

## Patentansprüche

1. Dynamisch regelbare Plasmaentladungsvorrichtung zum Entfernen von Material von einem Substrat, umfassend
einen sich in Längsrichtung erstreckenden Mikrowellenhohlraum,
eine Plasmaröhre, welche durch den Mikrowellenhohlraum hindurchgeht, zum Halten von Gas, wenn in Betrieb,
Mittel zum Bereitstellen eines Mikrowellenfeldes im Hohlraum zum Erregen von Gas, wenn sich dieses in der Plasmaröhre befindet, für ein Plasma, und
eine Öffnung in der Plasmaröhre, um dem Gas den Austritt zu gestatten, **dadurch gekennzeichnet, dass**
wenigstens ein Ende des Mikrowellenhohlraums durch eine Mikrowellenfalle, welche einen Mikrowellenstrom auf null verringert, wobei deren Position in Längsrichtung einstellbar ist, um eine dynamische Regelung des Hohlraums bereitzustellen.

2. Vorrichtung nach Anspruch 1, wobei beide Enden des Mikrowellenhohlraums durch Mikrowellenfallen definiert sind und die jeweiligen Positionen beider Mikrowellenfallen in Längsrichtung einstellbar sind, um eine dynamische Regelung des Hohlraums bereitzustellen.

3. Vorrichtung nach Anspruch 2, wobei das Mittel zum Bereitstellen eines Mikrowellenfeldes im Hohlraum Mikrowellenursprungsmittel zum Bereitstellen von Mikrowellenleistung und Mittel zum Verbinden der Mikrowellenleistung aus dem Ursprungsmittel mit dem Hohlraum umfasst, wobei die Mittel zum Verbinden eine Antenne, welche sich in den Hohlraum erstreckt, umfassen, deren Einschubgrad in den Hohlraum einstellbar ist.

4. Vorrichtung nach einem vorangehenden Anspruch, wobei das Gas aus einer Mehrzahl von Gasen, darunter Sauerstoff enthaltendes Gas und Fluor enthaltendes Gas, ausgewählt werden kann.

5. Vorrichtung nach einem vorangehenden Anspruch, des Weiteren umfassend Mittel zum Ausnutzen des Plasmas oder des Nachglühens desselben, um das Material vom Substrat zu entfernen.

6. Vorrichtung nach einem vorangehenden Anspruch, wobei die Mikrowellenfalle im Hohlraum entlang dessen Länge bewegbar ist und sie das Feld zwischen der Falle und dem Hohlraum auf null ohne den Einsatz irgendeines körperlichen Elements zwischen der Falle und dem Hohlraum zurückgehen lässt.

7. Vorrichtung nach Anspruch 6, wobei die Mikrowellenfalle aus drei konzentrischen, zylindrischen Metallelementen aufgebaut ist.

8. Vorrichtung nach Anspruch 7, wobei die drei konzentrischen, zylindrischen Metallelemente ein inneres zylindrisches Element, ein äußeres zylindrisches Element und ein dazwischenliegendes zylindrisches Element zwischen dem inneren und dem äußeren Element umfassen und wobei die Plasmaröhre durch das innere zylindrische Element hindurchgeht.

9. Vorrichtung nach Anspruch 8, wobei die Mikrowellenfalle das Feld zwischen der Plasmaröhre und dem inneren zylindrischen Metallelement null sein lässt.

10. Vorrichtung nach Anspruch 9, wobei die inneren und äußeren zylindrischen Elemente Teile eines ersten Stücks sind. Während das dazwischen liegende zylindrische Element Teil eines zweiten Stücks ist, wobei das zweite Stück in das erste Stück eingeschoben ist.

11. Vorrichtung nach Anspruch 10, wobei das Mittel zum Bereitstellen eines Mikrowellenfeldes im Hohlraum Mikrowellenursprungsmittel zum Bereitstellen von Mikrowellenleistung und Mittel zum Verbinden der Mikrowellenleistung aus dem Ursprungsmittel mit dem Hohlraum umfasst, wobei die Mittel zum Verbinden eine Antenne, welche sich in den Hohlraum erstreckt, umfassen, deren Einschubgrad in den Hohlraum einstellbar ist.

12. Vorrichtung nach einem vorangehenden Anspruch, wobei das Mittel zum Bereitstellen eines Mikrowellenfeldes im Hohlraum ein Feld bereitstellt, welches einen zylindrischen TM₀₁₂-Resonanzmodus aufweist.

13. Vorrichtung nach Anspruch 1, wobei das Mittel zum Bereitstellen eines Mikrowellenfeldes im Hohlraum Mikrowellenursprungsmittel zum Bereitstellen von Mikrowellenleistung und Mittel zum Verbinden der Mikrowellenleistung aus dem Ursprungsmittel mit dem Hohlraum umfasst, wobei die Mittel zum Verbinden eine Antenne, welche sich in den Hohlraum erstreckt, umfassen, deren Einschubgrad in den Hohlraum einstellbar ist, des Weiteren umfassend Mittel für jeden ausgewählten Materialentfernungsvorgang, zum automatischen Einstellen der jeweiligen Positionen der Mikrowellenfalle und der Antenne, so dass die reflektierte Mikrowellenleistung minimal ist.

14. Vorrichtung nach Anspruch 13, des Weiteren umfassend ein Datenspeichermittel zum Speichern von Daten, welche den Mikrowellenfallen- und Antennenpositionen für verschiedene Materialentfernungsvorgänge entsprechen.

15. Vorrichtung nach Anspruch 14, wobei die Mikrowellenfalle aus einem inneren zylindrischen Element, einem äußeren zylindrischen Element und einem dazwischenliegenden zylindrischen Element zwischen dem inneren und dem äußeren Element aufgebaut ist und wobei die Plasmaröhre durch das innere zylindrische Element hindurchgeht.
